# EUROPÄISCHE PATENTSCHRIFT

(11) **EP 3 723 220 B1**
(45) Veröffentlichungstag und Bekanntmachung des Hinweises auf die Patenterteilung: **09.02.2022**
(21) Anmeldenummer: 19167786.3
(22) Anmeldetag: 08.04.2019
(51) Int. Cl.: H02H 3/04, G01R 31/08, H02H 3/16, H02H 7/26

(54) **ORTEN EINES ERDSCHLUSSES IN EINEM GLEICHSTROMNETZ**
DETECTION OF AN EARTH FAULT IN A DC NETWORK
EMPLACEMENTS D'UNE PERTE À LA TERRE DANS UN RÉSEAU À COURANT CONTINUE

(43) Veröffentlichungstag der Anmeldung: 14.10.2020
(73) Patentinhaber: Siemens Aktiengesellschaft, 80333 München (DE)
(72) Erfinder: Schierling, Hubert, 91052 Erlangen (DE); Weis, Benno, 91334 Hemhofen (DE)

(56) Entgegenhaltungen:
- EP-A1- 2 860 838
- DE-A1-102017 108 822
- JP-A- H07 325 121
- US-A1- 2011 175 619

## Beschreibung

Die Erfindung betrifft ein Verfahren zum Orten eines Erdschlusses in einem Gleichstromnetz, dem mehrere Lastzonen zuschaltbar sind.

Ein gegenüber einem Erdpotential isoliertes oder über eine hohe Impedanz geerdetes Gleichstromnetz kann bei einem Erdschluss eines Gleichspannungspotentials weiter betrieben werden. Der Erdschluss selbst kann während des Betriebs durch die Messung und Auswertung der Spannungen zwischen den Gleichspannungspotentialen des Gleichstromnetzes und einem Erdpotential leicht detektiert werden. Allerdings ist es schwierig, diejenige am Gleichstromnetz angeschlossene Lastzone zu identifizieren, in der der Erdschluss aufgetreten ist. Die Identifizierung derjenigen Lastzone, in der der Erdschluss aufgetreten ist, ist jedoch wichtig, um die fehlerhafte Lastzone abzuschalten und den Erdschluss zu beseitigen. Um die fehlerhafte Lastzone zu identifizieren, könnte beispielsweise an einer Verbindungsstelle jeder Lastzone mit dem Gleichstromnetz, beispielsweise am Eingang eines Schaltschranks, ein so genannter Common-Mode-Strom, das heißt ein Fehlerstrom, der die Summe der Ströme in den beiden Anschlussleitungen der Lastzone zu den Hauptleitungen des Gleichstromnetzes ist, gemessen werden. Wenn einer der Common-Mode-Ströme von Null verschieden ist, weist dies darauf hin, dass der Erdschluss in der zugehörigen Lastzone aufgetreten ist. Die Messungen der Common-Mode-Ströme könnten beispielsweise permanent oder manuell durch Wartungspersonal durchgeführt werden. Jedoch sind derartige Messungen in jedem Fall aufwändig.

Ein Verfahren zum Orten eines Erdschlusses in einem symmetrisch geerdeten Gleichstromnetz, dem mehrere Lastzonen zuschaltbar sind, ist aus US 2011/175619 A1 bekannt. 11

Der Erfindung liegt die Aufgabe zugrunde, ein verbessertes Verfahren zum Orten eines Erdschlusses in einem Gleichstromnetz anzugeben, dem mehrere Lastzonen zuschaltbar sind.

Die Aufgabe wird erfindungsgemäß durch ein Verfahren mit den Merkmalen des Anspruchs 1 und ein Gleichstromnetz mit den Merkmalen des Anspruchs 7 gelöst.

Vorteilhafte Ausgestaltungen der Erfindung sind Gegenstand der Unteransprüche.

Das erfindungsgemäße Verfahren dient zum Orten eines Erdschlusses in einem Gleichstromnetz, dem mehrere Lastzonen zuschaltbar sind, wobei jede Lastzone zwei symmetrisch geerdete Lastzonenleitungen aufweist, wovon eine erste Lastzonenleitung mit einer ersten Hauptleitung des Gleichstromnetzes verbindbar ist und die zweite Lastzonenleitung mit einer zweiten Hauptleitung des Gleichstromnetzes verbindbar ist. Bei dem Verfahren wird fortlaufend für jede Lastzonenleitung eine Leitungsspannung zwischen einem Leitungspotential, auf dem die Lastzonenleitung liegt, und einem Erdpotential gemessen. Im Falle, dass an einer Hauptleitung des Gleichstromnetzes ein Erdschluss detektiert wird, werden die Hauptleitungen von beiden Lastzonenleitungen einer der Lastzonen getrennt und der Erdschluss wird dieser Lastzone zugeordnet, wenn sich eine Betragsdifferenz zwischen den Beträgen der Leitungsspannungen der beiden Lastzonenleitungen dieser Lastzone nach dem Trennen der Hauptleitungen von den Lastzonenleitungen nicht signifikant verkleinert. Unter einer symmetrischen Erdung der beiden Lastzonenleitungen einer Lastzone wird dabei eine gleichartige Erdung der beiden Lastzonenleitungen verstanden, die im erdschlussfreien Betrieb die Leitungspotentiale der Lastzonenleitungen symmetrisch um das Erdpotential hält, beispielsweise eine ohmsch-kapazitive Erdung beider Lastzonenleitungen durch jeweils eine Parallelschaltung eines Erdungskondensators und eines Erdungswiderstands mit Erdungskondensatoren gleicher Kapazitäten und Erdungswiderständen gleicher Widerstandswerte. Ferner wird hier und im Folgenden stets angenommen, dass das Gleichstromnetz gegenüber dem Erdpotential isoliert oder über eine hohe Impedanz geerdet ist. Die Verbindung einer Lastzonenleitung mit einer Hauptleitung des Gleichstromnetzes kann direkt oder indirekt sein, wobei eine indirekte Verbindung beispielsweise vorliegen kann, wenn das Gleichstromnetz hierarchisch aufgebaut ist, mit einer obersten Hierarchieebene, die direkt mit den Hauptleitungen verbunden ist, und wenigstens einer weiteren Hierarchieebene, die über die über ihr liegende Hierarchieebene oder die über ihr liegenden Hierarchieebenen mit den Hauptleitungen verbunden ist.

Das erfindungsgemäße Verfahren nutzt aus, dass ein Erdschluss, der eine Lastzonenleitung einer Lastzone betrifft, eine Asymmetrie der Leitungspotentiale der Lastzonenleitungen gegenüber dem Erdpotential bewirkt, so dass die beiden Leitungspotentiale nicht mehr symmetrisch um das Erdpotential liegen. Wenn der Erdschluss außerhalb der Lastzone, beispielsweise in einer anderen Lastzone oder direkt an einer Hauptleitung, erzeugt wird, so wird sich nach dem Trennen der Hauptleitungen von den Lastzonenleitungen der Lastzone wieder die Symmetrie der Leitungspotentiale der Lastzonenleitungen gegenüber dem Erdpotential einstellen, da sich der Erdschluss dann nicht mehr auf die Leitungspotentiale auswirkt. Wenn der Erdschluss hingegen in der Lastzone erzeugt wird, wird sich die Asymmetrie der Leitungspotentiale der Lastzonenleitungen gegenüber dem Erdpotential nach dem Trennen der Hauptleitungen von den Lastzonenleitungen nicht ändern oder sogar leicht erhöhen. Mit anderen Worten wird nach dem Trennen der Hauptleitungen von den Lastzonenleitungen einer Lastzone die Betragsdifferenz zwischen den Beträgen der Leitungsspannungen der beiden Lastzonenleitungen dieser Lastzone abnehmen, wenn der Erdschluss außerhalb der Lastzone erzeugt wird, und gleichbleiben oder zunehmen, wenn der Erdschluss innerhalb der Lastzone erzeugt wird. Dies wird erfindungsgemäß ausgenutzt, um einen an einer Hauptleitung detektierten Erdschluss zu orten.

Bei einer Ausgestaltung des Verfahrens wird eine Trennungsdauer vorgegeben und die Hauptleitungen werden nach dem Detektieren des Erdschlusses an einer Hauptleitung für die Trennungsdauer von den Lastzonenleitungen einer Lastzone getrennt. Diese Ausgestaltung des Verfahrens nutzt aus, dass in der Regel eine kurze Trennung der Hauptleitungen von den Lastzonenleitungen einer Lastzone ausreicht, um die Betragsdifferenz zwischen den Beträgen der Leitungsspannungen der beiden Lastzonenleitungen dieser Lastzone zu ermitteln und auszuwerten. Typischerweise reicht beispielsweise eine Trennung für eine Trennungsdauer im Bereich von 1 ms bis 1 s aus. Eine möglichst kurze Trennung der Hauptleitungen von den Lastzonenleitungen einer Lastzone ist vorteilhaft, um den Betrieb der Lastzone durch die Trennung möglichst wenig zu beeinträchtigen.

Bei einer weiteren Ausgestaltung des Verfahrens wird eine absolute oder relative Mindestverkleinerung vorgegeben und eine Verkleinerung der Betragsdifferenz zwischen den Beträgen der Leitungsspannungen der beiden Lastzonenleitungen einer Lastzone nach deren Trennen von den Hauptleitungen wird als signifikant eingestuft, wenn die Verkleinerung der Betragsdifferenz die Mindestverkleinerung übertrifft. Beispielsweise wird eine Mindestverkleinerung von 2 % bis 30 %, insbesondere von etwa 10 % einer Gleichspannung, die in einem Normalbetrieb des Gleichstromnetzes zwischen den Hauptleitungen liegt, vorgegeben. Durch die Vorgabe der Mindestverkleinerung für eine Betragsdifferenz zwischen den Beträgen der Leitungsspannungen kann quantifiziert werden, wann eine Verkleinerung der Betragsdifferenz nach dem Trennen der Hauptleitungen von den Lastzonenleitungen einer Lastzone als signifikant angesehen wird. Dadurch können Fehlortungen von Erdschlüssen aufgrund von nur geringen Verkleinerungen der Betragsdifferenz nach dem Trennen der Hauptleitungen von den Lastzonenleitungen einer Lastzone vorteilhaft reduziert oder ganz vermieden werden.

Bei einer weiteren Ausgestaltung des Verfahrens werden nach dem Detektieren eines Erdschlusses an einer Hauptleitung die Hauptleitungen nacheinander von den beiden Lastzonenleitungen verschiedener Lastzonen getrennt, bis der Erdschluss einer Lastzone zugeordnet wird. Dadurch kann systematisch nach einer Lastzone gesucht werden, in der der Erdschluss erzeugt wird. Wenn der Erdschluss nach Abschluss der Suche keiner Lastzone zugeordnet worden ist, kann ferner darauf geschlossen werden, dass der Erdschluss direkt an derjenigen Hauptleitung erzeugt wird, an der er auch detektiert wurde.

Ein erfindungsgemäßes Gleichstromnetz umfasst:
- zwei Hauptleitungen,
- mehrere Lastzonen, die jeweils eine erste Lastzonenleitung, die über einen ersten Schalter mit einer ersten Hauptleitung des Gleichstromnetzes verbindbar ist, und eine zweite Lastzonenleitung, die über einen zweiten Schalter mit der zweiten Hauptleitung des Gleichstromnetzes verbindbar ist, aufweisen,
- für jede Lastzonenleitung eine Messeinheit, die dazu eingerichtet ist, fortlaufend eine Leitungsspannung zwischen einem Leitungspotential, auf dem die Lastzonenleitung liegt, und einem Erdpotential zu messen,
- eine Erdschlussüberwachungseinheit, die dazu eingerichtet ist, Erdschlüsse an den Hauptleitungen zu detektieren,
- eine Steuereinheit zum Ansteuern der Schalter, die dazu eingerichtet ist, im Falle, dass an einer Hauptleitung des Gleichstromnetzes von der Erdschlussüberwachungseinheit ein Erdschluss detektiert wird, die Hauptleitungen von beiden Lastzonenleitungen einer Lastzone durch Öffnen der die Lastzonenleitungen mit den Hauptleitungen verbindenden Schalter zu trennen,
- und eine Auswerteeinheit zum Auswerten der Messsignale der Messeinheiten, die dazu eingerichtet ist, einen von der Erdschlussüberwachungseinheit detektierten Erdschluss der Lastzone zuzuordnen, die die von den Hauptleitungen getrennten Lastzonenleitungen aufweist, wenn sich eine Betragsdifferenz zwischen den Beträgen der Leitungsspannungen der beiden Lastzonenleitungen dieser Lastzone nach dem Trennen der Hauptleitungen von den Lastzonenleitungen nicht signifikant verkleinert.

Beispielsweise ist der erste Schalter oder der zweite Schalter jeder Lastzone ein elektronischer Schalter, oder beide Schalter sind elektronische Schalter.

Ferner kann die Steuereinheit dazu eingerichtet sein, die Hauptleitungen nach dem Detektieren eines Erdschlusses an einer Hauptleitung nur für eine vorgegebene Trennungsdauer, beispielsweise für eine Trennungsdauer im Bereich von 1 ms bis 1 s, von den Lastzonenleitungen einer Lastzone zu trennen.

Des Weiteren kann die Auswerteeinheit dazu eingerichtet sein, eine Verkleinerung der Betragsdifferenz zwischen den Beträgen der Leitungsspannungen der beiden Lastzonenleitungen einer Lastzone nach dem Trennen der Hauptleitungen von diesen Lastzonenleitungen als signifikant einzustufen, wenn die Verkleinerung der Betragsdifferenz eine vorgegebene Mindestverkleinerung übertrifft.

Ein erfindungsgemäßes Gleichstromnetz ermöglicht die Durchführung des erfindungsgemäßen Verfahrens mit den oben bereits genannten Vorteilen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockschaltbild eines Gleichstromnetzes, dem mehrere Lastzonen zuschaltbar sind,
FIG 2 ein Blockschaltbild einer Lastzone und einer Zuschalteinheit, mit der dem Gleichstromnetz die Lastzone zuschaltbar ist.

Einander entsprechende Teile sind in den Figuren mit denselben Bezugszeichen versehen.

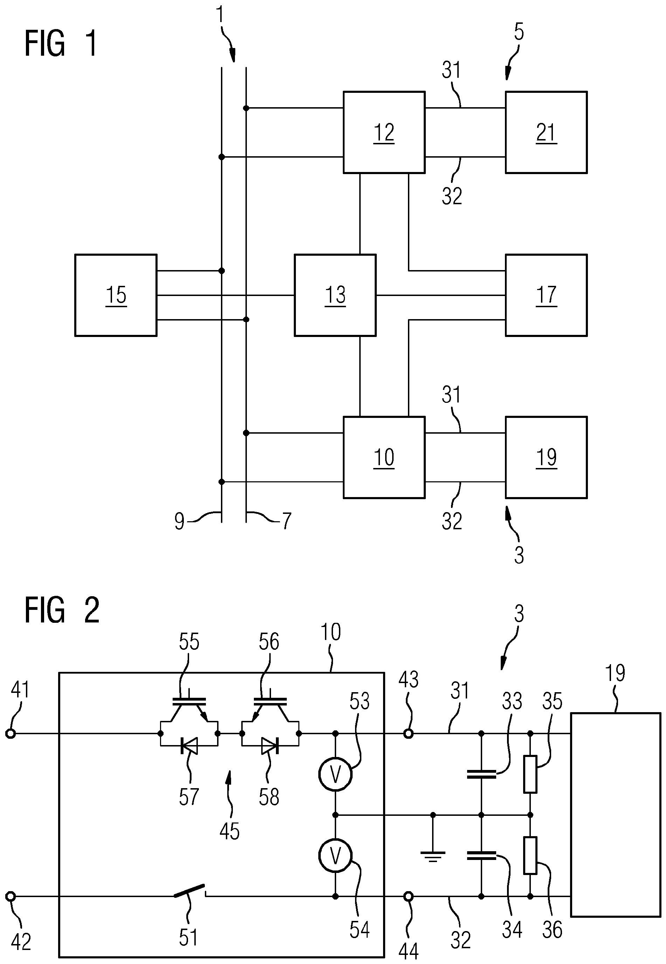

Figur 1 zeigt schematisch ein Ausführungsbeispiel eines Gleichstromnetzes 1, dem mehrere Lastzonen 3, 5 zuschaltbar sind. Das Gleichstromnetz 1 ist gegenüber einem Erdpotential isoliert oder über eine hohe Impedanz geerdet.

Das Gleichstromnetz 1 weist zwei elektrische Hauptleitungen 7, 9, für jede Lastzone 3, 5 eine Zuschalteinheit 10, 12 sowie eine Steuereinheit 13, eine Erdschlussüberwachungseinheit 15 und eine Auswerteeinheit 17 auf.

In Figur 1 sind beispielhaft zwei Lastzonen 3, 5 dargestellt. Jede Lastzone 3, 5 weist eine elektrische Last 19, 21, beispielsweise eine elektrische Maschine und einen der elektrischen Maschine netzseitig vorgeschalteten Stromrichter, auf.

Eine erste Hauptleitung 7 liegt auf einem ersten Gleichspannungspotential des Gleichstromnetzes 1. Die zweite Hauptleitung 9 liegt auf einem zweiten Gleichspannungspotential des Gleichstromnetzes 1.

Jede Zuschalteinheit 10, 12 ist einer Lastzone 3, 5 zugeordnet, die dem Gleichstromnetz 1 durch die Zuschaltschalteinheit 10, 12 zuschaltbar ist.

Die Steuereinheit 13 ist mit den Zuschalteinheiten 10, 12, der Erdschlussüberwachungseinheit 15 und der Auswerteeinheit 17 verbunden. Von der Steuereinheit 13 wird das Zuschalten der Lastzonen 3, 5 gesteuert.

Die Erdschlussüberwachungseinheit 15 ist dazu eingerichtet, Erdschlüsse an den Hauptleitungen 7, 9 zu detektieren. Dazu ist die Erdschlussüberwachungseinheit 15 mit jeder Hauptleitung 7, 9 verbunden und dazu eingerichtet, die Spannungen zwischen dem Erdpotential und den Gleichspannungspotentialen, auf denen die Hauptleitungen 7, 9 liegen, zu messen. Ferner ist die Erdschlussüberwachungseinheit 15 dazu eingerichtet, der Steuereinheit 13 einen detektierten Erdschluss zu melden.

Die Auswerteeinheit 17 ist mit der Steuereinheit 13 und den Zuschalteinheiten 10, 12 verbunden und dazu eingerichtet, in unten näher beschriebener Weise Leitungsspannungen der Lastzonen 3, 5 auszuwerten.

Figur 2 zeigt beispielhaft ein Blockschaltbild der Lastzone 3 und der Zuschalteinheit 10, mit der die Lastzone 3 dem Gleichstromnetz 1 zuschaltbar ist.

Die Lastzone 3 weist eine erste Lastzonenleitung 31 auf, die über eine Parallelschaltung eines ersten Erdungskondensators 33 und eines ersten Erdungswiderstands 35 hochimpedant ohmsch-kapazitiv geerdet ist. Ferner weist die Lastzone 3 eine zweite Lastzonenleitung 32 auf, die über eine Parallelschaltung eines zweiten Erdungskondensators 34 und eines zweiten Erdungswiderstands 36 hochimpedant ohmsch-kapazitiv geerdet ist. Dabei sind die beiden Lastzonenleitungen 31, 32 symmetrisch geerdet, wobei die Erdungskondensatoren 33 gleiche Kapazitäten und die Erdungswiderstände 35, 36 gleiche Widerstandswerte aufweisen, um Lastzonenpotentiale, auf denen die Lastzonenleitungen 31, 32 liegen, im fehlerfreien Betrieb symmetrisch zu dem Erdpotential zu halten.

Die Zuschalteinheit 10 weist zwei netzseitige Anschlüsse 41, 42, zwei lastzonenseitige Anschlüsse 43, 44, zwei Schalter 45, 51 und zwei Messeinheiten 53, 54 auf.

Ein erster netzseitiger Anschluss 41 ist mit der ersten Hauptleitung 7 verbunden. Der zweite Anschluss 42 ist mit der zweiten Hauptleitung 9 verbunden. Ein erster lastzonenseitiger Anschluss 43 ist mit der ersten Lastzonenleitung 31 verbunden. Der zweite lastzonenseitige Anschluss 44 ist mit der zweiten Lastzonenleitung 32 verbunden.

Ein erster Schalter 45 ist zwischen den ersten netzseitigen Anschluss 41 und den ersten lastzonenseitigen Anschluss 43 geschaltet. Der erste Schalter 45 ist ein elektronischer Schalter, der zwei abschaltbare Halbleiterschalter 55, 56 und zwei Dioden 57, 58 aufweist. Die Halbleiterschalter 55, 56 sind antiseriell geschaltet, das heißt die Halbleiterschalter 55, 56 sind in Reihe, aber mit einander entgegensetzten Durchlassrichtungen geschaltet. Jede Diode 57, 58 ist antiparallel zu einem der Halbleiterschalter 55, 56 geschaltet. Der erste Schalter 45 ist als ein schneller Schalter ausgebildet, der Kurzschlussströme abschalten kann.

Der zweite Schalter 51 ist zwischen den zweiten netzseitigen Anschluss 42 und den zweiten lastzonenseitigen Anschluss 44 geschaltet. Der zweite Schalter 51 ist beispielsweise ein mechanischer Lasttrennschalter. Alternativ kann auch der zweite Schalter 51 als ein elektronischer Schalter wie der erste Schalter 45 ausgebildet sein. Der erste Schalter 45 (beziehungsweise dessen Halbleiterschalter 55, 56) und der zweite Schalter 51 sind von der Steuereinheit 13 ansteuerbar.

Eine erste Messeinheit 53 ist dazu eingerichtet, fortlaufend eine der ersten Lastzonenleitung 31 zugeordnete erste Leitungsspannung zwischen dem Leitungspotential, auf dem die erste Lastzonenleitung 31 liegt, und dem Erdpotential zu messen. Die zweite Messeinheit 54 ist dazu eingerichtet, fortlaufend eine der zweiten Lastzonenleitung 32 zugeordnete zweite Leitungsspannung zwischen dem Leitungspotential, auf dem die zweite Lastzonenleitung 32 liegt, und dem Erdpotential zu messen. Die Messeinheiten 53, 54 übertragen die von ihnen erfassten Messsignale zu der Auswerteeinheit 17.

Die zweite Lastzone 5 (und jede weitere dem Gleichstromnetz 1 zuschaltbare Lastzone) weist ebenfalls zwei symmetrisch geerdete Lastzonenleitungen 31, 32 auf und ist dem Gleichstromnetz 1 durch eine wie die Zuschalteinheit 10 ausgebildete Zuschalteinheit 12 zuschaltbar.

Erfindungsgemäß werden im Falle, dass an einer Hauptleitung 7, 9 des Gleichstromnetzes 1 ein Erdschluss detektiert wird, beide Hauptleitungen 7, 9 von den mit ihnen verbundenen Lastzonenleitungen 31, 32 einer Lastzone 3, 5 durch ein von der Steuereinheit 13 veranlasstes Öffnen der die Lastzonenleitungen 31, 32 mit den Hauptleitungen 3, 5 verbindenden Schalter 45, 51 für eine vorgegebene kurze Trennungsdauer getrennt, beispielsweise für eine Trennungsdauer im Bereich von 1 ms bis 1 s.

Nach dem Trennen der Hauptleitungen 7, 9, von den Lastzonenleitungen 31, 32 einer Lastzone 3, 5 wird von der Auswerteeinheit 17 geprüft, ob sich eine Betragsdifferenz zwischen den Beträgen der Leitungsspannungen der beiden Lastzonenleitungen 31, 32 dieser Lastzone 3, 5 nicht signifikant verkleinert oder sich die Beträge der Leitungsspannungen der beiden Lastzonenleitungen 31, 32 angleichen. Wenn sich die Betragsdifferenz nicht signifikant verkleinert, ordnet die Auswerteeinheit 17 den Erdschluss dieser Lastzone 3, 5 zu.

Ferner kann vorgesehen sein, dass die Hauptleitungen 7, 9 nach dem Detektieren eines Erdschlusses an einer Hauptleitung 7, 9 nacheinander von beiden Lastzonenleitungen 31, 32 verschiedener Lastzonen 3, 5 jeweils für eine vorgegebene Trennungsdauer getrennt wird bis der Erdschluss einer Lastzone 3, 5 zugeordnet wird.

Das Trennen der Hauptleitungen 7, 9 von den Lastzonenleitungen 31, 32 einer Lastzone 3, 5 wird vorzugsweise zu einem Zeitpunkt vorgenommen, zu dem die Last 19, 21 der Lastzone 3, 5 keine Energie benötigt oder die benötigte Energie für die Trennungsdauer gepuffert werden kann, beispielsweise durch einen (nicht dargestellten) Speicherkondensator, der zwischen die Lastzonenleitungen 31, 32 der Lastzone 3, 5 geschaltet ist.

Die anhand der Figuren beschriebenen Ausführungsbeispiele des erfindungsgemäßen Verfahrens und eines erfindungsgemäßen Gleichstromnetzes 1 können auf verschiedene Weisen zu weiteren Ausführungsbeispielen abgewandelt werden. Beispielsweise kann vorgesehen sein, dass die Auswerteeinheit 17 in die Steuereinheit 13 oder in die Erdschlussüberwachungseinheit 15 integriert ist. Alternativ kann vorgesehen sein, dass statt einer übergeordneten Auswerteeinheit 17 für jede Zuschalteinheit 10, 12 eine lokale Auswerteeinheit 17 vorgesehen ist, die die Leitungsspannungen der Lastzonenleitungen 31, 32 der Zuschalteinheit 10, 12 auswertet. Zusätzlich kann vorgesehen sein, dass jede Zuschalteinheit 10, 12 eine lokale Steuereinheit 13 aufweist, die dazu eingerichtet ist, im Falle, dass an einer Hauptleitung 7, 9 des Gleichstromnetzes 1 ein Erdschluss detektiert wird, die Schalter 45, 51 der Zuschalteinheit 10, 12 für eine Trennungsdauer zu öffnen. Auch dabei kann eine lokale Auswerteeinheit 17 in die lokale Steuereinheit 13 integriert sein.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der in den Ansprüchen definierten Erfindung zu verlassen.

## Patentansprüche

1. Verfahren zum Orten eines Erdschlusses in einem Gleichstromnetz (1), dem mehrere Lastzonen (3, 5) zuschaltbar sind, wobei jede Lastzone (3, 5) zwei symmetrisch geerdete Lastzonenleitungen (31, 32) aufweist, wovon eine erste Lastzonenleitung (31) mit einer ersten Hauptleitung (7) des Gleichstromnetzes (1) verbindbar ist und die zweite Lastzonenleitung (32) mit einer zweiten Hauptleitung (9) des Gleichstromnetzes (1) verbindbar ist, **dadurch gekennzeichnet, dass** Z
- fortlaufend für jede Lastzonenleitung (31, 32) eine Leitungsspannung zwischen einem Leitungspotential, auf dem die Lastzonenleitung (31, 32) liegt, und einem Erdpotential gemessen wird, und
- im Falle, dass an einer Hauptleitung (7, 9) des Gleichstromnetzes (1) ein Erdschluss detektiert wird, die Hauptleitungen (7, 9) von beiden Lastzonenleitungen (31, 32) einer Lastzone (3, 5) getrennt werden und der Erdschluss dieser Lastzone (3, 5) zugeordnet wird, wenn sich eine Betragsdifferenz zwischen den Beträgen der Leitungsspannungen der beiden Lastzonenleitungen (31, 32) dieser Lastzone (3, 5) nach dem Trennen der Hauptleitungen (7, 9) von den Lastzonenleitungen (31, 32) nicht signifikant verkleinert.

2. Verfahren nach Anspruch 1, wobei eine Trennungsdauer vorgegeben wird und die Hauptleitungen (7, 9) nach dem Detektieren des Erdschlusses an einer Hauptleitung (7, 9) für die Trennungsdauer von den Lastzonenleitungen (31, 32) einer Lastzone (3, 5) getrennt werden.

3. Verfahren nach Anspruch 2, wobei eine Trennungsdauer im Bereich von 1 ms bis 1 s vorgegeben wird.

4. Verfahren nach einem der vorhergehenden Ansprüche, wobei jede Hauptleitung (7, 9) von der mit ihr verbundenen Lastzonenleitung (31, 32) durch das Öffnen eines zwischen der Hauptleitung (7, 9) und der Lastzonenleitung (31, 32) angeordneten Schalters (45, 51) getrennt wird.

5. Verfahren nach einem der vorhergehenden Ansprüche, wobei eine absolute oder relative Mindestverkleinerung vorgegeben wird und eine Verkleinerung der Betragsdifferenz zwischen den Beträgen der Leitungsspannungen der beiden Lastzonenleitungen (31, 32) einer Lastzone (3, 5) nach dem Trennen der Hauptleitungen (7, 9) von diesen Lastzonenleitungen (31, 32) als signifikant eingestuft wird, wenn die Verkleinerung der Betragsdifferenz die Mindestverkleinerung übertrifft.

6. Verfahren nach einem der vorhergehenden Ansprüche, wobei nach dem Detektieren eines Erdschlusses an einer Hauptleitung (7, 9) die Hauptleitungen (7, 9) nacheinander von den beiden Lastzonenleitungen (31, 32) verschiedener Lastzonen (3, 5) getrennt werden, bis der Erdschluss einer Lastzone (3, 5) zugeordnet wird.

7. Gleichstromnetz (1), umfassend
- zwei Hauptleitungen (7, 9),
- mehrere Lastzonen (3, 5), die jeweils eine erste Lastzonenleitung (31), die über einen ersten Schalter (45) mit einer ersten Hauptleitung (7) des Gleichstromnetzes (1) verbindbar ist, und eine zweite Lastzonenleitung (32), die über einen zweiten Schalter (51) mit der zweiten Hauptleitung (9) des Gleichstromnetzes (1) verbindbar ist, aufweisen,
**dadurch gekennzeichnet, dass** das Gleichstromnetz weiter umfasst:
- für jede Lastzonenleitung (31, 32) eine Messeinheit (53, 54), die dazu eingerichtet ist, fortlaufend eine Leitungsspannung zwischen einem Leitungspotential, auf dem die Lastzonenleitung (31, 32) liegt, und einem Erdpotential zu messen,
- eine Erdschlussüberwachungseinheit (15), die dazu eingerichtet ist, Erdschlüsse an den Hauptleitungen (7, 9) zu detektieren,
- eine Steuereinheit (13) zum Ansteuern der Schalter (45, 51), die dazu eingerichtet ist, im Falle, dass an einer Hauptleitung (7, 9) des Gleichstromnetzes (1) von der Erdschlussüberwachungseinheit (15) ein Erdschluss detektiert wird, die Hauptleitungen (7, 9) von beiden Lastzonenleitungen (31, 32) einer Lastzone (3, 5) durch Öffnen der die Lastzonenleitungen (31, 32) mit den Hauptleitungen (7, 9) verbindenden Schalter (45, 51) zu trennen,
- und eine Auswerteeinheit (17) zum Auswerten der Messsignale der Messeinheiten (53, 54), die dazu eingerichtet ist, einen von der Erdschlussüberwachungseinheit (15) detektierten Erdschluss der Lastzone (3, 5) zuzuordnen, die die von den Hauptleitungen (7, 9) getrennten Lastzonenleitungen (31, 32) aufweist, wenn sich eine Betragsdifferenz zwischen den Beträgen der Leitungsspannungen der beiden Lastzonenleitungen (31, 32) dieser Lastzone (3, 5) nach dem Trennen der Hauptleitungen (7, 9) von den Lastzonenleitungen (31, 32) nicht signifikant verkleinert.

8. Gleichstromnetz (1) nach Anspruch 7, wobei der erste Schalter (45) und/oder der zweite Schalter (51) jeder Lastzone (3, 5) ein elektronischer Schalter ist.

9. Gleichstromnetz (1) nach Anspruch 7 oder 8, wobei die Steuereinheit (13) dazu eingerichtet ist, die Hauptleitungen (7, 9) nach dem Detektieren des Erdschlusses an einer Hauptleitung (7, 9) nur für eine vorgegebene Trennungsdauer von den Lastzonenleitungen (31, 32) einer Lastzone (3, 5) zu trennen.

10. Gleichstromnetz (1) nach einem der Ansprüche 7 bis 9, wobei die Auswerteeinheit (17) dazu eingerichtet ist, eine Verkleinerung der Betragsdifferenz zwischen den Beträgen der Leitungsspannungen der beiden Lastzonenleitungen (31, 32) einer Lastzone (3, 5) nach dem Trennen der Hauptleitungen (7, 9) von diesen Lastzonenleitungen (31, 32) als signifikant einzustufen, wenn die Verkleinerung der Betragsdifferenz eine vorgegebene Mindestverkleinerung übertrifft.

## Claims

1. Method for locating a ground fault in a DC network (1), to which a plurality of load zones (3, 5) can be connected, wherein each load zone (3, 5) has two symmetrically grounded load zone lines (31, 32), a first load zone line (31) of which can be connected to a first main line (7) of the DC network (1) and the second load zone line (32) of which can be connected to a second main line (9) of the DC network (1), **characterized in that**
- a line voltage is continuously measured for each load zone line (31, 32) between a line potential of the load zone line (31, 32) and a ground potential, and
- if a ground fault is detected on a main line (7, 9) of the DC network (1), the main lines (7, 9) are disconnected from the two load zone lines (31, 32) of a load zone (3, 5) and the ground fault is assigned to this load zone (3, 5) if a magnitude difference between the magnitudes of the line voltages of the two load zone lines (31, 32) of this load zone (3, 5) does not significantly decrease after the main lines (7, 9) have been disconnected from the load zone lines (31, 32).

2. Method according to Claim 1, wherein a disconnection period is predefined and the main lines (7, 9) are disconnected from the load zone lines (31, 32) of a load zone (3, 5) for the disconnection period after the ground fault has been detected on a main line (7, 9).

3. Method according to Claim 2, wherein a disconnection period in the range of 1 ms to 1 s is predefined.

4. Method according to one of the preceding claims, wherein each main line (7, 9) is disconnected from the load zone line (31, 32) connected to it by opening a switch (45, 51) arranged between the main line (7, 9) and the load zone line (31, 32).

5. Method according to one of the preceding claims, wherein an absolute or relative minimum decrease is predefined and a decrease in the magnitude difference between the magnitudes of the line voltages of the two load zone lines (31, 32) of a load zone (3, 5) after the main lines (7, 9) have been disconnected from these load zone lines (31, 32) is classified as significant if the decrease in the magnitude difference exceeds the minimum decrease.

6. Method according to one of the preceding claims, wherein, after a ground fault has been detected on a main line (7, 9), the main lines (7, 9) are disconnected in succession from the two load zone lines (31, 32) of different load zones (3, 5) until the ground fault is assigned to a load zone (3, 5).

7. DC network (1) comprising
- two main lines (7, 9),
- a plurality of load zones (3, 5) each having a first load zone line (31), which can be connected to a first main line (7) of the DC network (1) via a first switch (45), and a second load zone line (32), which can be connected to the second main line (9) of the DC network (1) via a second switch (51),
- a measurement unit (53, 54) for each load zone line (31, 32), which measurement unit is configured to continuously measure a line voltage between a line potential of the load zone line (31, 32) and a ground potential,
**characterized in that** the DC network further comprises:
- a ground fault monitoring unit (15) which is configured to detect ground faults on the main lines (7, 9),
- a control unit (13) for controlling the switches (45, 51), which control unit is configured to disconnect the main lines (7, 9) from the two load zone lines (31, 32) of a load zone (3, 5), if a ground fault is detected on a main line (7, 9) of the DC network (1) by the ground fault monitoring unit (15), by opening the switches (45, 51) connecting the load zone lines (31, 32) to the main lines (7, 9),
- and an evaluation unit (17) for evaluating the measurement signals from the measurement units (53, 54), which evaluation unit is configured to assign a ground fault detected by the ground fault monitoring unit (15) to that load zone (3, 5) which has the load zone lines (31, 32) disconnected from the main lines (7, 9) if a magnitude difference between the magnitudes of the line voltages of the two load zone lines (31, 32) of this load zone (3, 5) does not significantly decrease after the main lines (7, 9) have been disconnected from the load zone lines (31, 32).

8. DC network (1) according to Claim 7, wherein the first switch (45) and/or the second switch (51) of each load zone (3, 5) is/are an electronic switch.

9. DC network (1) according to Claim 7 or 8, wherein the control unit (13) is configured to disconnect the main lines (7, 9) from the load zone lines (31, 32) of a load zone (3, 5) only for a predefined disconnection period after the ground fault has been detected on a main line (7, 9).

10. DC network (1) according to one of Claims 7 to 9, wherein the evaluation unit (17) is configured to classify a decrease in the magnitude difference between the magnitudes of the line voltages of the two load zone lines (31, 32) of a load zone (3, 5) after the main lines (7, 9) have been disconnected from these load zone lines (31, 32) as significant if the decrease in the magnitude difference exceeds a predefined minimum decrease.

## Revendications

1. Procédé de localisation d'un défaut à la terre dans un réseau à courant continu (1) auquel plusieurs zones de charge (3, 5) peuvent être raccordées, dans lequel chaque zone de charge (3, 5) comprend deux lignes de zone de charge (31, 32) mises à la terre symétriquement, dont une première ligne de zone de charge (31) peut être reliée à une première ligne principale (7) du réseau à courant continu (1) et la deuxième ligne de zone de charge (32) peut être reliée à une deuxième ligne principale (9) du réseau à courant continu (1), **caractérisé en ce que**
- pour chaque ligne de zone de charge (31, 32), une tension de ligne est mesurée en continu entre un potentiel de ligne, sur lequel se trouve la ligne de zone de charge (31, 32), et un potentiel de terre, et
- dans le cas où un défaut à la terre est détecté au niveau d'une ligne principale (7, 9) du réseau à courant continu (1), les lignes principales (7, 9) sont séparées des deux lignes de zone de charge (31, 32) d'une zone de charge (3, 5) et le défaut à la terre est associé à cette zone de charge (3, 5), lorsqu'une différence de valeur entre les valeurs des tensions de ligne des deux lignes de zone de charge (31, 32) de cette zone de charge (3, 5) n'est pas significativement réduite après la séparation des lignes principales (7, 9) des lignes de zone de charge (31, 32).

2. Procédé selon la revendication 1, dans lequel une durée de séparation est prédéfinie et les lignes principales (7, 9), après la détection du défaut à la terre au niveau d'une ligne principale (7, 9), sont séparées des lignes de zone de charge (31, 32) d'une zone de charge (3, 5) pendant la durée de séparation.

3. Procédé selon la revendication 2, dans lequel une durée de séparation est prédéfinie dans la gamme allant de 1 ms à 1 s.

4. Procédé selon l'une des revendications précédentes, dans lequel chaque ligne principale (7, 9) est séparée de la ligne de zone de charge reliée à elle (31, 32) par l'ouverture d'un commutateur (45, 51) disposé entre la ligne principale (7, 9) et la ligne de zone de charge (31, 32).

5. Procédé selon l'une des revendications précédentes, dans lequel une réduction minimale absolue ou relative est prédéfinie et une réduction de la différence de valeur entre les valeurs des tensions de ligne des deux lignes de zone de charge (31, 32) d'une zone de charge (3, 5) après la séparation des lignes principales (7, 9) de ces lignes de zone de charge (31, 32) est considérée comme significative lorsque la réduction de la différence de valeur dépasse la réduction minimale.

6. Procédé selon l'une des revendications précédentes, dans lequel, après la détection d'un défaut à la terre au niveau d'une ligne principale (7, 9), les lignes principales (7, 9) sont séparées l'une après l'autre des deux lignes de zone de charge (31, 32) de zones de charge différentes (3, 5) jusqu'à ce que le défaut à la terre soit associé à une zone de charge (3, 5).

7. Réseau à courant continu (1), comportant
- deux lignes principales (7, 9),
- plusieurs zones de charge (3, 5), qui comprennent respectivement une première ligne de zone de charge (31) qui peut être reliée à une première ligne principale (7) du réseau à courant continu (1) par l'intermédiaire d'un premier commutateur (45), et une deuxième ligne de zone de charge (32) qui peut être reliée à la deuxième ligne principale (9) du réseau à courant continu (1) par l'intermédiaire d'un deuxième commutateur (51), **caractérisé en ce que** le réseau à courant continu comporte en outre :
- pour chaque ligne de zone de charge (31, 32), une unité de mesure (53, 54), qui est conçue pour mesurer en continu une tension de ligne entre un potentiel de ligne, sur lequel se trouve la ligne de zone de charge (31, 32), et un potentiel de terre,
- une unité de surveillance des défauts à la terre (15), qui est conçue pour détecter des défauts à la terre au niveau des lignes principales (7, 9),
- une unité de commande (13) pour la commande des commutateurs (45, 51), qui est conçue pour, dans le cas où un défaut à la terre est détecté au niveau d'une ligne principale (7, 9) du réseau à courant continu (1) par l'unité de surveillance des défauts à la terre (15), séparer les lignes principales (7, 9) des deux lignes de zone de charge (31, 32) d'une zone de charge (3, 5) par l'ouverture des commutateurs (45, 51) reliant les lignes de zone de charge (31, 32) aux lignes principales (7, 9),
- et une unité d'évaluation (17) pour l'évaluation des signaux de mesure des unités de mesure (53, 54), qui est conçue pour associer un défaut à la terre détecté par l'unité de surveillance des défauts à la terre (15) à la zone de charge (3, 5) qui comprend les lignes de zone de charge (31, 32) séparées des lignes principales (7, 9), lorsqu'une différence de valeur entre les valeurs des tensions de ligne des deux lignes de zone de charge (31, 32) de cette zone de charge (3, 5) n'est pas significativement réduite après la séparation des lignes principales (7, 9) des lignes de zone de charge (31, 32) .

8. Réseau à courant continu (1) selon la revendication 7, dans lequel le premier commutateur (45) et/ou le deuxième commutateur (51) de chaque zone de charge (3, 5) est un commutateur électronique.

9. Réseau à courant continu (1) selon la revendication 7 ou 8, dans lequel l'unité de commande (13) est conçue pour séparer les lignes principales (7, 9) des lignes de zone de charge (31, 32) d'une zone de charge (3, 5) seulement pendant une durée de séparation prédéfinie, après la détection du défaut à la terre au niveau d'une ligne principale (7, 9).

10. Réseau à courant continu (1) selon l'une des revendications 7 à 9, dans lequel l'unité d'évaluation (17) est conçue pour considérer comme significative une réduction de la différence de valeur entre les valeurs des tensions de ligne des deux lignes de zone de charge (31, 32) d'une zone de charge (3, 5) après la séparation des lignes principales (7, 9) de ces lignes de zone de charge (31, 32) lorsque la réduction de la différence de valeur dépasse une réduction minimale prédéfinie.
